# EUROPEAN PATENT SPECIFICATION

(11) **EP 3 557 698 B1**
(45) Date of publication and mention of the grant of the patent: **04.08.2021**
(21) Application number: 19168564.3
(22) Date of filing: 11.04.2019
(51) Int. Cl.: G02B 6/42, H01R 12/72

(54) **CONNECTOR ASSEMBLY**
VERBINDERBAUGRUPPE
ENSEMBLE CONNECTEUR

(30) Priority: 18.04.2018 CN 201810349368
(43) Date of publication of application: 23.10.2019
(73) Proprietor: Tyco Electronics (Shanghai) Co., Ltd., China (Shanghai) Pilot Free Trade Zone Shanghai (CN); TE Connectivity Svenska AB, 194 26 Upplands Vasby (SE)
(72) Inventor: WAN, Qingquan, Dongguan, Guangdong 523071 (CN); SONG, Zhigang, Xuhui District, Shanghai 200233 (CN); ANDERSSON, Hans Magnus Emil, 194 26 Upplands Vasby (SE); ZHANG, Haibo, Xuhui District, Shanghai 200233 (CN); LIU, Songhua, Dongguan, Guangdong 523071 (CN)
(74) Representative: Grünecker Patent- und Rechtsanwälte PartG mbB

(56) References cited:
- US-A1- 2016 064 873
- US-B1- 6 986 679

## Description

### BACKGROUND OF THE INVENTION

### Field of the Invention

Embodiments of the disclosure relate to a connector assembly.

### Description of the Related Art

In the related art, a connector assembly typically comprises a receptacle, a connection base, and a plug. The receptacle is fixed on a circuit board located in a communication device, the connection base is fixed on a housing panel of the communication device, and the plug is fixed on the connection base. The plug has a front end passing through the connector base and the housing panel of the communication device and be plugged into the receptacle.

In the related art, since the receptacle is not in contact with the connection base, a heat generated inside the communication device cannot be transferred to the connection base. Therefore, the heat is retained inside a housing of the communication device without being easily dissipated, which may cause a temperature inside the communication device too high, and the communication device would malfunction due to the high temperature.

Document US 2016/064873 discloses a connector assembly according to the preamble of claim 1.

### SUMMARY OF THE INVENTION

Embodiments of the disclosure have been made to overcome or alleviate at least one aspect of the above mentioned disadvantages.

According to one aspect of the disclosure, there is provided a connector assembly adapted to connect a plug to a communication device. The connector assembly comprises a receptacle adapted to be fixed on a circuit board of the communication device and mated with the plug, and a connection base adapted to be fixed on a housing panel of the communication device. The connection base has a main body portion located outside the housing panel of the communication device. The connection base is formed with an insertion cavity adapted to receive at least a portion of the receptacle. The connection base is in thermal contact with the receptacle.

According to an exemplary embodiment of the disclosure, the receptacle is mounted with a heat dissipating block adapted to be in thermal contact with an inner wall of the connection base.

According to another exemplary embodiment of the disclosure, the heat dissipating block is formed with a first boss on a top surface thereof. The first boss 121 is in thermal contact with the inner wall of the connection base when the receptacle is inserted into the connection base.

According to further another exemplary embodiment of the disclosure, the heat dissipating block is further formed with a second boss on a bottom surface thereof. The second boss protrudes into the receptacle via an opening in a casing of the receptacle. The second boss is in thermal contact with the plug when the plug is plugged into the receptacle.

According to yet another exemplary embodiment of the disclosure, the main body portion of the connection base has an outer wall formed with a heat radiating rib protruding outwardly.

According to still another exemplary embodiment of the disclosure, the main body portion of the connection base has a cylindrical shape. The heat radiating rib has an annular sheet shape and is formed to surround around an outer circumferential wall of the main body portion of the connection base.

According to further another exemplary embodiment of the disclosure, the outer wall of the main body portion of the connection base is formed with a plurality of heat dissipating ribs distributed separately in an axial direction of the connection base.

According to yet another exemplary embodiment of the disclosure, the connection base has one end extending into an interior of a housing of the communication device via a through hole in the housing panel of the communication device.

According to still another exemplary embodiment of the disclosure, the connection base comprises a flange protruding from an outer wall thereof and adapted to be fixed onto the housing panel of the communication device.

According to further another exemplary embodiment of the disclosure, an elastic sealing ring is disposed between the flange of the connection base and the housing panel of the communication device and compressed therebetween for sealing between the connector base and the housing panel of the communication device.

According to yet another exemplary embodiment of the disclosure, the plug comprises an outer housing adapted to be latched onto the other end of the connection base opposite to the one end.

According to still another exemplary embodiment of the disclosure, the plug further comprises an inner housing disposed within the outer housing. An elastic sealing ring is disposed between the inner housing and the other end of the connection base and compressed therebetween for sealing between the connection base and the plug.

According to further another exemplary embodiment of the disclosure, the plug is an optical cable plug comprising a fiber optic connector adapted to be optically connected with an optical cable and a photoelectric conversion module adapted to be optically connected with the fiber optic connector. The fiber optic connector is disposed within the inner housing, and the photoelectric conversion module is adapted to be inserted into the receptacle and electrically connected with the circuit board within the communication device.

According to yet another exemplary embodiment of the disclosure, the photoelectric conversion module comprises a converting circuit board, which is adapted to convert an optical signal into an electrical signal or to convert an electrical signal into an optical signal.

According to still another exemplary embodiment of the disclosure, positioning grooves are formed in inner walls at both side of the insertion cavity of the connection base, and side edges at both sides of the converting circuit board are inserted and positioned in the positioning grooves.

According to further another exemplary embodiment of the disclosure, the plug is an electrical cable plug comprising an electrical connector adapted to be electrically connected with an electrical cable. The electrical connector is disposed within the inner housing and adapted to be inserted into the receptacle and electrically connected with the circuit board within the communication device.

According to still another exemplary embodiment of the disclosure, the inner housing of the plug is mounted with an electromagnetic shielding elastic sheet on a front thereof. The electromagnetic shielding elastic sheet is adapted to be in elastic electrical contact with an inner wall of a cylindrical main body portion of the connection base.

In the foregoing various exemplary embodiments according to the disclosure, the connection base is in thermal contact with the receptacle. Thus, it is possible for the heat inside the communication device to be transferred to the connection base and rapidly dissipated outside the communication device through the connection base, thereby improving the heat dissipation performance of the communication device and effectively preventing the communication device from malfunction due to overheating.

Other objects and advantages of the disclosure will become apparent from the following description of the disclosure when taken in conjunction with the accompanying drawings, and may give a comprehensive understanding of the disclosure.

### BRIEF DESCRIPTION OF THE DRAWINGS

The above and other features of the disclosure will become more apparent by describing in detail exemplary embodiments thereof with reference to the accompanying drawings, in which:
FIG. 1A shows a schematic assembled view of a connector assembly in accordance with a first embodiment of the disclosure;
FIG. 1B shows a longitudinal cross-sectional view of the connector assembly shown in FIG. 1A;
FIG. 2 shows a schematic exploded view of the connector assembly shown in FIG. 1A;
FIG. 3 shows a plan view of a connection base of the connector assembly shown in FIG. 2 as viewed from the end;
FIG. 4 shows a schematic exploded view of a connector assembly in accordance with another embodiment of the disclosure; and
FIG. 5 shows a plan view of a connection base of the connector assembly shown in FIG. 4 as viewed from the end.

### DETAILED DESCRIPTION OF PREFERRED EMBODIMENTS OF THE INVENTION

The technical solution of the disclosure will be described hereinafter in further detail with reference to the following embodiments, taken in conjunction with the accompanying drawings. In the specification, the same or similar reference numerals indicate the same or similar parts. The description of the embodiments of the disclosure hereinafter with reference to the accompanying drawings is intended to explain the general inventive concept of the disclosure and should not be construed as a limitation on the disclosure.

In addition, in the following detailed description, for the sake of explanation, numerous specific details are set forth in order to provide a thorough understanding of the disclosed embodiments. It will be apparent, however, that one or more embodiments may also be practiced without these specific details. In other instances, well-known structures and devices are illustrated schematically in order to simplify the drawing.

According to a general technical concept of the disclosure, there is provided a connector assembly adapted to connect a plug to a communication device. The connector assembly comprises a receptacle adapted to be fixed to a circuit board of the communication device and mated with the plug, and a connection base adapted to be fixed on a housing panel of the communication device. The connection base has a main body portion located outside the housing panel of the communication device. The connection base is formed with an insertion cavity adapted to receive at least a portion of the receptacle. The connection base is in thermal contact with the receptacle.

### First embodiment

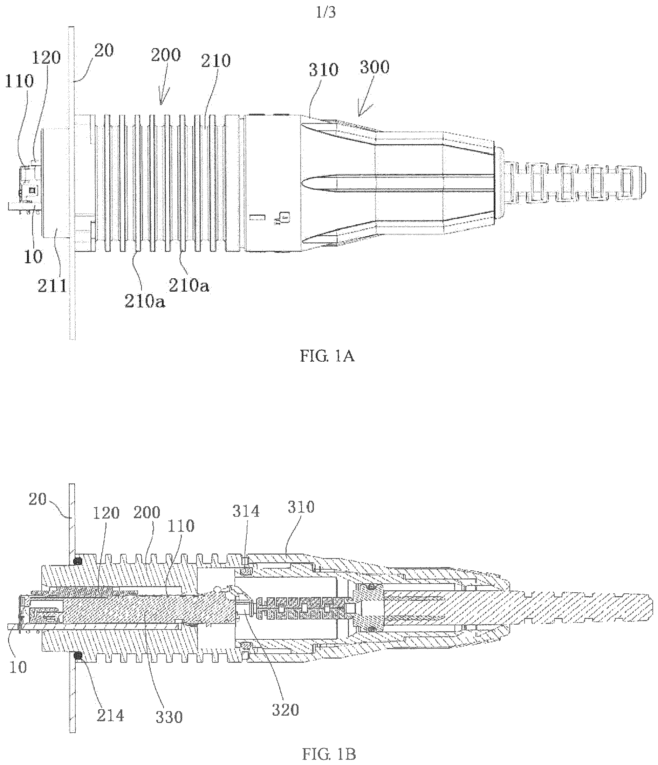

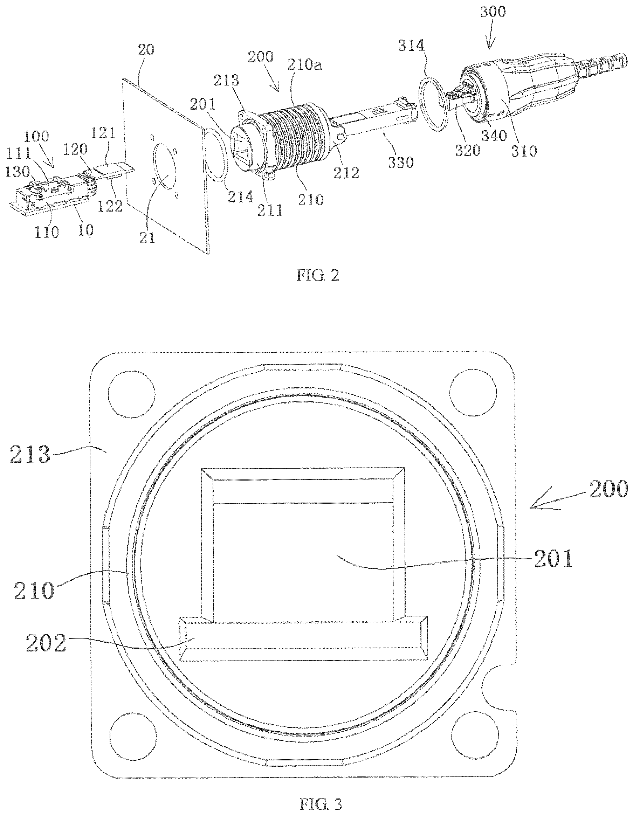

FIGS. 1A to 3 show a connector assembly in accordance with a first embodiment of the disclosure, wherein FIG. 1A shows a schematic assembled view of a connector assembly in accordance with a first embodiment of the disclosure, FIG. 1B shows a longitudinal cross-sectional view of the connector assembly shown in FIG. 1A; FIG. 2 shows a schematic exploded view of the connector assembly shown in FIG. 1A; and FIG. 3 shows a plan view of a connection base of the connector assembly shown in FIG. 2 as viewed from the end;

As shown in FIGS. 1A to 3, in the illustrated embodiment, the connector assembly is adapted to connect a plug 300 to a communication device. The connector assembly mainly comprises: a receptacle 100 and a connection base 200. The receptacle 100 is fixed on a circuit board 10 located in a housing of a communication device (not shown). The connection base 200 is fixed on a housing panel 20 of the communication device. The plug 300 is adapted to be mated with the receptacle 100, i.e., the plug 300 is adapted to be plugged into the receptacle 100.

As shown in FIGS. 1A to 3, in the illustrated embodiment, the connection base 200 has a main body portion 210 located outside the housing panel 20 of the communication device, and the connection base 200 is formed with an insertion cavity 201 adapted to receive at least a portion of the receptacle 100. The receptacle 100 is inserted into the insertion cavity 201 from one end 211 of the connection base 200, and the plug 300 is inserted into the insertion cavity 201 from the other end 212 of the connection base 200 and plugged into the receptacle 100.

As shown in FIGS. 1A to 3, in the illustrated embodiment, the connection base 200 is in thermal contact with the receptacle 100 inserted into the insertion cavity 201 of the connection base 200. In this way, heat inside the communication device may be transferred to the connection base 200 through the receptacle 100 and rapidly dissipated outside of the communication device through the connection base 200, thereby improving the heat dissipation performance of the communication device and effectively preventing the communication device from malfunction due to overheating.

As shown in FIGS. 1A to 3, in the illustrated embodiment, the receptacle 100 includes a heat dissipating block 120 mounted on a top portion of a casing 110 of the receptacle 100. The heat dissipating block 120 is adapted to be in thermal contact with an inner wall of the connection base 200.

As shown in FIG. 1A to FIG. 3, in the illustrated embodiment, the heat dissipating block 120 is formed with a first boss 121 on a top surface thereof. The first boss 121 is in thermal contact with the inner wall of the connection base 200 when the receptacle 100 is inserted into the connection base 200.

As shown in FIG. 1A to FIG. 3, in the illustrated embodiment, the heat dissipating block 120 is further formed with a second boss 122 on a bottom surface thereof. The second boss 122 is arranged to protrude into the receptacle 100 via an opening 111 in the casing 110. When the plug 300 is plugged into the receptacle 100, the second boss 122 is in thermal contact with the plug 300.

As shown in FIGS. 1A to 3, in the illustrated embodiment, the main body portion 210 of the connection base 200 has an outer wall formed with a heat radiating rib 210a protruding outwardly.

As shown in FIG. 1A to FIG. 3, in the illustrated embodiment, the main body portion 210 of the connection base 200 has a cylindrical shape. The heat radiating rib 210a has an annular sheet shape and is formed to surround around an outer circumferential wall of the main body portion 210 of the connection base 200.

As shown in FIGS. 1A to 3, in the illustrated embodiment, the outer wall of the main body portion 210 of the connection base 200 is formed with a plurality of heat dissipating ribs 210a, which are distributed separately in an axial direction of the connection base 200.

As shown in FIGS. 1A to 3, in the illustrated embodiment, the one end 211 of the connection base 200 extends into an interior of the housing of the communication device via a through hole 21 in the housing panel 20 of the communication device.

As shown in FIGS. 1A to 3, in the illustrated embodiment, the connection base 200 includes a flange 213 protruding from the outer wall thereof. The flange 213 is adapted to be fixed onto the housing panel 20 of the communication device.

As shown in FIGS. 1A to 3, in the illustrated embodiment, an elastic sealing ring 214 is disposed between the flange 213 of the connection base 200 and the housing panel 20 of the communication device and compressed therebetween for sealing between the connector base 200 and the housing panel 20 of the communication device.

As shown in FIGS. 1A to 3, in the illustrated embodiment, the plug 300 includes an outer housing 310 adapted to be latched onto the other end 212 of the connection base 200.

As shown in FIGS. 1A to 3, in the illustrated embodiment, the plug 300 further includes an inner housing 340 disposed within the outer housing 310. An elastic sealing ring 314 is disposed between the inner housing 340 and the other end 212 of the connection base 200 and compressed therebetween for sealing between the connection base 200 and the plug 300.

As shown in FIGS. 1A to 3, in the illustrated embodiment, the plug 300 comprises an optical cable plug including a fiber optic connector 320 adapted to be optically connected with an optical cable (not shown) and a photoelectric conversion module 330 adapted to be optically connected with the fiber optic connector 320. The fiber optic connector 320 is disposed within the inner housing 340, and the photoelectric conversion module 330 is adapted to be inserted into the receptacle 100 and electrically connected with the circuit board 10 within the communication device.

As shown in FIGS. 1A to 3, in the illustrated embodiment, the photoelectric conversion module 330 includes a converting circuit board (not shown) adapted to convert an optical signal into an electrical signal or vice versa.

As shown in FIG. 1A to FIG. 3, in the illustrated embodiment, positioning grooves 202 are formed in the inner walls at both sides of the insertion cavity 201 of the connection base 200, and side edges at both sides of the converting circuit board are inserted and positioned in the positioning grooves 202.

### Second embodiment

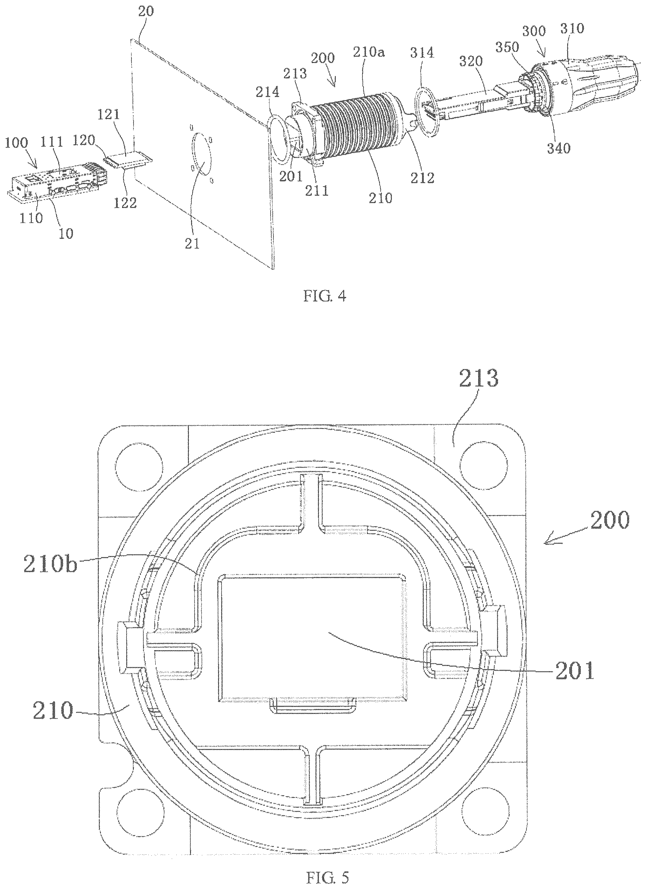

FIGS. 4 and 5 show a connector assembly according to a second embodiment of the disclosure, wherein FIG. 4 shows a schematic exploded view of a connector assembly in accordance with another embodiment of the disclosure, and FIG. 5 shows a plan view of a connection base of the connector assembly shown in FIG. 4 as viewed from the end.

As shown in FIGS. 4 and 5, in the illustrated embodiment, the connector assembly is adapted to connect a plug 300 to a communication device. The connector assembly mainly comprises: a receptacle 100 and a connection base 200. The receptacle 100 is fixed on a circuit board 10 located in a housing of a communication device (not shown). The connection base 200 is fixed on a housing panel 20 of the communication device. The plug 300 is adapted to be mated with the receptacle 100, i.e., the plug 300 is adapted to be plugged into the receptacle 100.

As shown in FIGS. 4 and 5, in the illustrated embodiment, the connection base 200 has a main body portion 210 located outside the housing panel 20 of the communication device, and the connection base 200 is formed with an insertion cavity 201 adapted to receive at least a portion of the receptacle 100. The receptacle 100 is inserted into the insertion cavity 201 from one end 211 of the connection base 200, and the plug 300 is inserted into the insertion cavity 201 from the other end 212 of the connection base 200 and plugged into the receptacle 100.

As shown in FIGS. 4 and 5, in the illustrated embodiment, the connection base 200 is in thermal contact with the receptacle 100 inserted into the insertion cavity 201 of the connection base 200. In this way, heat inside the communication device may be transferred to the connection base 200 through the receptacle 100 and rapidly dissipated outside of the communication device through the connection base 200, thereby improving the heat dissipation performance of the communication device and effectively preventing the communication device from malfunction due to overheating.

As shown in FIGS. 4 and 5, in the illustrated embodiment, the receptacle 100 includes a heat dissipating block 120 mounted on a top portion of a casing 110 of the receptacle 100. The heat dissipating block 120 is adapted to be in thermal contact with an inner wall of the connection base 200.

As shown in FIGS. 4 and 5, in the illustrated embodiment, the heat dissipating block 120 is formed with a first boss 121 on a top surface thereof. The first boss 121 is in thermal contact with the inner wall of the connection base 200 when the receptacle 100 is inserted into the connection base 200.

As shown in FIGS. 4 and 5, in the illustrated embodiment, the heat dissipating block 120 is formed with a second boss 122 on a bottom surface thereof. The second boss 122 is arranged to protrude into the receptacle 100 via an opening 111 in the casing 110. When the plug 300 is plugged into the receptacle 100, the second boss 122 is in thermal contact with the plug 300.

As shown in FIGS. 4 and 5, in the illustrated embodiment, an outer wall of the main body portion 210 of the connection base 200 is formed with a heat radiating rib 210a protruding outwardly.

As shown in FIGS. 4 and 5, in the illustrated embodiment, the main body portion 210 of the connection base 200 has a cylindrical shape, the heat radiating rib 210a has an annular sheet shape, and the heat radiating rib 210a is formed to surround around an outer circumferential wall of the main body portion 210 of the connection base 200.

As shown in FIGS. 4 and 5, in the illustrated embodiment, the outer wall of the main body portion 210 of the connection base 200 is formed with a plurality of heat dissipating ribs 210a which are distributed separately in an axial direction of the connection base 200.

As shown in FIGS. 4 and 5, in the illustrated embodiment, the one end 211 of the connection base 200 extends into an interior of the housing of the communication device via a through hole 21 in the housing panel 20 of the communication device.

As shown in FIGS. 4 and 5, in the illustrated embodiment, the connection base 200 includes a flange 213 protruding from the outer wall thereof. The flange 213 is adapted to be fixed onto the housing panel 20 of the communication device.

As shown in FIGS. 4 and 5, in the illustrated embodiment, an elastic sealing ring 214 is disposed between the flange 213 of the connection base 200 and the housing panel 20 of the communication device and is compressed therebetween for sealing between the connector base 200 and the housing panel 20 of the communication device.

As shown in FIGS. 4 and 5, in the illustrated embodiment, the plug 300 includes an outer housing 310 adapted to be latched onto the other end 212 of the connection base 200.

As shown in FIGS. 4 and 5, in the illustrated embodiment, the plug 300 further includes an inner housing 340 disposed within the outer housing 310. An elastic sealing ring 314 is disposed between the inner housing 340 and the other end 212 of the connection base 200 and compressed therebetween for sealing between the connection base 200 and the plug 300.

As shown in FIGS. 4 and 5, in the illustrated embodiment, the plug 300 comprises an electrical cable plug including an electrical connector 320 adapted to be electrically connected with an electrical cable (not shown). The electrical connector 320 is disposed within the inner housing 340 and adapted to be inserted into the receptacle 100 and electrically connected with the circuit board 10 within the communication device.

As shown in FIGS. 4 and 5, in the illustrated embodiment, the inner housing 340 of the plug 300 is mounted with an electromagnetic shielding elastic sheet 350 on a front thereof. The electromagnetic shielding elastic sheet 350 is adapted to be in elastic electrical contact with the inner wall of the cylindrical main body portion of the connection base 200.

In another exemplary embodiment of the disclosure, as shown in FIG. 5, the inner wall of the connection base 200 may be also formed with a protruding heat dissipation rib 210b to further increase heat dissipation area of the connection base 200.

It should be appreciated by those skilled in this art that the above embodiments are intended to be illustrative, and many modifications may be made to the above embodiments by those skilled in this art, and various structures described in various embodiments may be freely combined with each other without conflicting in configuration or principle.

Although the disclosure have been described hereinbefore in detail with reference to the attached drawings, it should be appreciated that the disclosed embodiments in the attached drawings are intended to illustrate the preferred embodiments of the disclosure by way of example, and should not be construed as limitation to the disclosure.

Although several exemplary embodiments have been shown and described, it would be appreciated by those skilled in the art that various changes or modifications may be made to these embodiments without departing the scope of the claims and their equivalents.

It should be noted that, the word "comprise" doesn't exclude other elements or steps, and the word "a" or "an" doesn't exclude more than one. In addition, any reference numerals in the claims should not be interpreted as the limitation to the scope of the disclosure.

## Claims

1. A connector assembly adapted to connect a plug (300) to a communication device, comprising:
a receptacle (100) adapted to be fixed on a circuit board (10) of the communication device and mated with the plug (300); and
a connection base (200) adapted to be fixed on a housing panel (20) of the communication device,
**characterized in that** the connection base (200) has a main body portion (210) located outside the housing panel (20) of the communication device, the connection base (200) is formed with an insertion cavity (201) adapted to receive at least a portion of the receptacle (100), and the connection base (200) is in thermal contact with the receptacle (100).

2. The connector assembly according to claim 1, wherein the receptacle (100) is mounted with a heat dissipating block (120) adapted to be in thermal contact with an inner wall of the connection base (200).

3. The connector assembly according to claim 2, wherein the heat dissipating block (120) is formed with a first boss (121) on a top surface thereof, the first boss (121) being in thermal contact with the inner wall of the connection base (200) when the receptacle (100) is inserted into the connection base (200).

4. The connector assembly according to claim 3, wherein
the heat dissipating block (120) is further formed with a second boss (122) on a bottom surface thereof, the second boss (122) protruding into the receptacle (100) via an opening (111) in a casing (110) of the receptacle (100); and
the second boss (122) is in thermal contact with the plug (300) when the plug (300) is plugged into the receptacle (100).

5. The connector assembly according to any one of claims 1-4, wherein the main body portion (210) of the connection base (200) has an outer wall formed with a heat radiating rib (210a) protruding outwardly.

6. The connector assembly according to claim 5, wherein
the main body portion (210) of the connection base (200) has a cylindrical shape; and
the heat radiating rib (210a) has an annular sheet shape and is formed to surround around an outer circumferential wall of the main body portion (210) of the connection base (200).

7. The connector assembly according to claim 6, wherein the outer wall of the main body portion (210) of the connection base (200) is formed with a plurality of heat dissipating ribs (210a) which are distributed separately in an axial direction of the connection base (200).

8. The connector assembly according to any one of claims 1-7, wherein the connection base (200) has one end (211) extending into an interior of a housing of the communication device via a through hole (21) in the housing panel (20) of the communication device.

9. The connector assembly according to any one of claims 1-8, wherein the connection base (200) comprises a flange (213) protruding from an outer wall thereof and adapted to be fixed onto the housing panel (20) of the communication device.

10. The connector assembly according to claim 9, wherein an elastic sealing ring (214) is disposed between the flange (213) of the connection base (200) and the housing panel (20) of the communication device and compressed therebetween for sealing between the connector base (200) and the housing panel (20) of the communication device.

11. The connector assembly according to any one of claims 1-10, wherein the plug (300) comprises an outer housing (310) adapted to be latched onto the other end (212) of the connection base (200) opposite to the one end (211) and wherein the plug (300) further comprises an inner housing (340) disposed within the outer housing (310); and
an elastic sealing ring (314) is disposed between the inner housing (340) and the other end (212) of the connection base (200) and compressed therebetween for sealing between the connection base (200) and the plug (300).

12. The connector assembly according to claim 11, wherein
the plug (300) comprises an optical cable plug comprising a fiber optic connector (320) adapted to be optically connected with an optical cable and a photoelectric conversion module (330) adapted to be optically connected with the fiber optic connector (320); and
the fiber optic connector (320) is disposed within the inner housing (340), and the photoelectric conversion module (330) is adapted to be inserted into the receptacle (100) and electrically connected with the circuit board (10) within the communication device and wherein the photoelectric conversion module (330) comprises a converting circuit board, which is adapted to convert an optical signal into an electrical signal or to convert an electrical signal into an optical signal.

13. The connector assembly according to claim 12, wherein positioning grooves (202) are formed in inner walls at both side of the insertion cavity (201) of the connection base (200), and side edges at both sides of the converting circuit board are inserted and positioned in the positioning grooves (202).

14. The connector assembly according to claim 11, wherein
the plug (300) comprises an electrical cable plug comprising an electrical connector (320) adapted to be electrically connected with an electrical cable; and
the electrical connector (320) is disposed within the inner housing (340) and adapted to be inserted into the receptacle (100) and electrically connected with the circuit board (10) within the communication device.

15. The connector assembly according to claim 14, wherein the inner housing (340) of the plug (300) is mounted with an electromagnetic shielding elastic sheet (350) on a front thereof, the electromagnetic shielding elastic sheet (350) being adapted to be in elastic electrical contact with an inner wall of a cylindrical main body portion (210) of the connection base (200).

## Patentansprüche

1. Verbinderanordnung, die zum Verbinden eines Steckers (300) mit einer Kommunikationsvorrichtung eingerichtet ist, wobei sie umfasst:
eine Buchse (100), die so eingerichtet ist, dass sie an einer Leiterplatte (10) der Kommunikationsvorrichtung befestigt werden und mit dem Stecker (300) in Eingriff gebracht wird; sowie
einen Verbindungssockel (200), der zum Befestigen an einer Gehäuseplatte (20) der Kommunikationsvorrichtung eingerichtet ist,
**dadurch gekennzeichnet, dass** der Verbindungssockel (200) einen Hauptkörperabschnitt (210) aufweist, der sich außerhalb der Gehäuseplatte (20) der Kommunikationsvorrichtung befindet, und der Verbindungssockel (200) mit einem Einführungs-Hohlraum (201) versehen ist, der zum Aufnehmen wenigstens eines Abschnitts der Buchse (100) eingerichtet ist, und der Verbindungssockel (200) in thermischem Kontakt mit der Buchse (100) ist.

2. Verbinderanordnung nach Anspruch 1, wobei an der Buchse (100) ein wärmeableitender Block (120) montiert ist, der so eingerichtet ist, dass er in thermischem Kontakt mit einer Innenwand des Verbindungssockels (200) ist.

3. Verbinderanordnung nach Anspruch 2, wobei der wärmeableitende Block (120) mit einer ersten Wulst (121) an seiner Oberseite versehen ist, und die erste Wulst (121) in thermischem Kontakt mit der Innenwand des Verbindungssockels (200) ist, wenn die Buchse (100) in den Verbindungssockel (200) eingeführt ist.

4. Verbinderanordnung nach Anspruch 3, wobei
der wärmeableitende Block (120) des Weiteren mit einer zweiten Wulst (122) an seiner Unterseite versehen ist, wobei die zweite Wulst (122) über eine Öffnung (111) in einem Gehäuse (110) der Buchse (100) in die Buchse (100) hinein vorsteht; und
die zweite Wulst (122) in thermischem Kontakt mit dem Stecker (300) ist, wenn der Stecker (300) in die Buchse (100) eingesteckt ist.

5. Verbinderanordnung nach einem der Ansprüche 1 - 4, wobei der Hauptkörperabschnitt (210) des Verbindungssockels (200) eine Außenwand aufweist, die mit einer wärmeabstrahlenden Rippe (210a) versehen ist, die nach außen vorsteht.

6. Verbinderanordnung nach Anspruch 5, wobei
der Hauptkörperabschnitt (210) des Verbindungssockels (200) eine zylindrische Form hat; und
die wärmeabstrahlende Rippe (210a) eine ringartige Plattenform hat und so ausgebildet ist, dass sie eine Außenumfangswand des Hauptkörperabschnitts (210) des Verbindungssockels (200) umgibt.

7. Verbinderanordnung nach Anspruch 6, wobei die Außenwand des Hauptkörperabschnitts (210) des Verbindungssockels (200) mit einer Vielzahl wärmeableitender Rippen (210a) versehen ist, die separat in einer axialen Richtung des Verbindungssockels (200) verteilt sind.

8. Verbinderanordnung nach einem der Ansprüche 1 - 7, wobei der Verbindungssockel (200) ein Ende (211) hat, das sich über ein Durchgangsloch (21) in der Gehäuseplatte (20) der Kommunikationsvorrichtung in einen Innenraum eines Gehäuses der Kommunikationsvorrichtung hinein erstreckt.

9. Verbinderanordnung nach einem der Ansprüche 1 - 8, wobei der Verbindungssockel (200) einen Flansch (213) umfasst, der von einer Außenwand desselben vorsteht und zum Befestigen an der Gehäuseplatte (20) der Kommunikationsvorrichtung eingerichtet ist.

10. Verbinderanordnung nach Anspruch 9, wobei ein elastischer Dichtungsring (214) zwischen dem Flansch (213) des Verbindungssockels (200) und der Gehäuseplatte (20) der Kommunikationsvorrichtung angeordnet ist und zum Abdichten zwischen dem Verbindungssockel (200) und der Gehäuseplatte (20) der Kommunikationsvorrichtung zwischen ihnen zusammengedrückt wird.

11. Verbinderanordnung nach einem der Ansprüche 1 - 10, wobei der Stecker (300) ein äußeres Gehäuse (310) umfasst, das so eingerichtet ist, dass es an dem anderen Ende (212) des Verbindungssockels (200) arretiert wird, das dem einen Ende (211) gegenüberliegt, und wobei der Stecker (300) des Weiteren ein inneres Gehäuse (340) aufweist, das im Inneren des äußeren Gehäuses (310) angeordnet ist; und
ein elastischer Dichtungsring (314) zwischen dem inneren Gehäuse (340) und dem anderen Ende (212) des Verbindungssockels (200) angeordnet ist und zum Abdichten zwischen dem Verbindungssockel (200) und dem Stecker (300) zwischen ihnen zusammengedrückt wird.

12. Verbinderanordnung nach Anspruch 11, wobei
der Stecker (300) einen Lichtleiterkabel-Stecker, der einen faseroptischen Verbinder (320) umfasst, der zum optischen Verbinden mit einem Lichtleiterkabel eingerichtet ist, sowie ein photoelektrisches Umwandlungs-Modul (330) umfasst, das zum optischen Verbinden mit dem faseroptischen Verbinder (320) eingerichtet ist; und
der faseroptische Verbinder (320) im Inneren des inneren Gehäuses (340) angeordnet ist, und das photoelektrische Umwandlungs-Modul (330) so eingerichtet ist, das es in die Buchse (100) eingeführt und elektrisch mit der Leiterplatte (10) im Inneren der Kommunikationsvorrichtung verbunden wird, und wobei das photoelektrische Umwandlungs-Modul (330) eine Umwandlungs-Leiterplatte umfasst, die zum Umwandeln eines optischen Signals in ein elektrisches Signal oder zum Umwandeln eines elektrischen Signals in ein optisches Signal eingerichtet ist.

13. Verbinderanordnung nach Anspruch 12, wobei Positionier-Nuten (202) in Innenwänden an beiden Seiten des Einführungs-Hohlraums (201) des Verbindungssockels (200) ausgebildet sind und Seitenkanten an beiden Seiten der Umwandlungs-Leiterplatte in die Positionier-Nuten (202) eingeführt und darin positioniert werden.

14. Verbinderanordnung nach Anspruch 11, wobei
der Stecker (300) einen Stromkabel-Stecker umfasst, der einen elektrischen Verbinder (320) umfasst, der zum elektrischen Verbinden mit einem Stromkabel eingerichtet ist; und
der elektrische Verbinder (320) im Inneren des inneren Gehäuses (340) angeordnet und so eingerichtet ist, dass er in die Buchse (100) eingeführt und elektrisch mit der Leiterplatte (10) im Inneren der Kommunikationsvorrichtung verbunden wird.

15. Verbinderanordnung nach Anspruch 14, wobei an dem inneren Gehäuse (340) des Steckers (300) eine elektromagnetisch abschirmende elastische Scheibe (350) an einer Vorderseite desselben angebracht ist, und die elektromagnetisch abschirmende elastische Scheibe (350) so eingerichtet ist, dass sie in elastischem elektrischem Kontakt mit einer Innenwand eines zylindrischen Hauptkörperabschnitts (210) des Verbindungssockels (200) ist.

## Revendications

1. Ensemble connecteur adapté pour connecter une prise (300) à un dispositif de communication, comprenant :
un réceptacle (100) adapté pour être fixé sur une carte de circuits (10) du dispositif de communication et couplé à la prise (300) ; et
une base de connexion (200) adaptée pour être fixée sur un panneau de boîtier (20) du dispositif de communication,
**caractérisé en ce que** la base de connexion (200) présente une partie de corps principal (210) située hors du panneau de boîtier (20) du dispositif de communication, la base de connexion (200) est constituée d'une cavité d'insertion (201) adaptée pour accueillir au moins une partie du réceptacle (100), et la base de connexion (200) est en contact thermique avec le réceptacle (100).

2. L'ensemble connecteur selon la revendication 1, dans lequel le réceptacle (100) est monté avec un bloc dissipateur de chaleur (120) adapté pour être en contact thermique avec une paroi intérieure de la base de connexion (200).

3. L'ensemble connecteur selon la revendication 2, dans lequel le bloc dissipateur de chaleur (120) est constitué d'un premier bossage (121) sur une surface sommitale, le premier bossage (121) étant en contact thermique avec la paroi intérieure de la base de connexion (200) lorsque le réceptacle (100) est inséré dans la base de connexion (200).

4. L'ensemble connecteur selon la revendication 3, dans lequel
le bloc dissipateur de chaleur (120) est constitué en outre d'un deuxième bossage (122) sur une surface de fond de celui-ci, le deuxième bossage (122) débordant dans le réceptacle (100) via une ouverture (111) dans une coque (110) du réceptacle (100) ; et
le deuxième bossage (122) est en contact thermique avec la prise (300) lorsque la prise (300) est branchée dans le réceptacle (100).

5. L'ensemble connecteur selon l'une quelconque des revendications 1 à 4, dans lequel la partie de corps principal (210) de la base de connexion (200) présente une paroi extérieure constituée d'une ailette de rayonnement de chaleur (210a) débordant vers l'extérieur.

6. L'ensemble connecteur selon la revendication 5, dans lequel
la partie de corps principal (210) de la base de connexion (200) présente une forme cylindrique ; et
l'ailette de rayonnement de chaleur (210a) présente une forme de film annulaire et est constituée pour entourer une paroi circonférentielle extérieure de la partie de corps principal (210) de la connexion de base (200).

7. L'ensemble connecteur selon la revendication 6, dans lequel la paroi extérieure de la partie de corps principal (210) de la base de connexion (200) est constituée d'une pluralité d'ailettes de dissipation de chaleur (210a) qui sont réparties séparément dans une direction axiale de la base de connexion (200).

8. L'ensemble connecteur selon l'une quelconque des revendications 1 à 7, dans lequel la base de connexion (200) présente une extrémité (211) s'étendant dans un intérieur d'un boîtier du dispositif de communication via un trou traversant (21) dans le panneau de boîtier (20) du dispositif de communication.

9. L'ensemble connecteur selon l'une quelconque des revendications 1 à 8, dans lequel la base de connexion (200) comprend une bride (213) débordant depuis une paroi extérieure de celle-ci et adaptée pour être fixée sur le panneau de boîtier (20) du dispositif de communication.

10. L'ensemble connecteur selon la revendication 9, dans lequel un anneau d'étanchéité élastique (214) est disposé entre la bride (213) de la base de connexion (200) et le panneau de boîtier (20) du dispositif de communication et comprimé entre ceux-ci pour fournir une étanchéité entre la base de connecteur (200) et le panneau de boîtier (20) du dispositif de communication.

11. L'ensemble connecteur selon l'une quelconque des revendications 1 à 10, dans lequel la prise (300) comprend un boîtier extérieur (310) adapté pour être verrouillé sur l'autre extrémité (212) de la base de connexion (200) opposée à l'une extrémité (211) et dans lequel la prise (300) comprend en outre un boîtier intérieur (340) disposé au sein du boîtier extérieur ; et
un anneau d'étanchéité élastique (314) est disposé entre le boîtier intérieur (340) et l'autre extrémité (212) de la base de connexion (200) et comprimé entre ceux-ci pour fournir une étanchéité entre la base de connexion (200) et la prise (300).

12. L'ensemble connecteur selon la revendication 11, dans lequel
la prise (300) comprend une prise de câble optique comprenant un connecteur de fibre optique (320) adapté pour être connecté optiquement à un câble optique et un module de conversion photoélectrique (330) adapté pour être connecté optiquement au connecteur de fibre optique (320) ; et
le connecteur de fibre optique (320) est disposé au sein du boîtier intérieur (340), et le module de conversion photoélectrique (330) est adapté pour être inséré dans le réceptacle (100) et électriquement connecté à la carte de circuits (10) au sein du dispositif de communication et
dans lequel le module de conversion photoélectrique (330) comprend une carte de circuits de conversion, qui est adaptée pour convertir un signal optique en un signal électrique ou pour convertir un signal électrique en un signal optique.

13. L'ensemble connecteur selon la revendication 12, dans lequel des rainures de positionnement (202) sont constituées dans des parois intérieures des deux côtés de la cavité d'insertion (201) de la base de connexion (200), et des arêtes latérales des deux côtés de la carte de circuits de conversion sont insérées et positionnées dans les rainures de positionnement (202).

14. L'ensemble connecteur selon la revendication 11, dans lequel
la prise (300) comprend une prise de câble électrique comprenant un connecteur électrique (320) adapté pour être connecté électriquement à un câble électrique ; et
le connecteur électrique (320) est disposé au sein du boîtier intérieur (340), et adapté pour être inséré dans le réceptacle (100) et électriquement connecté à la carte de circuits (10) au sein du dispositif de communication.

15. L'ensemble connecteur selon la revendication 14, dans lequel le boîtier intérieur (340) de la prise (300) est monté avec un film élastique de blindage électromagnétique (350) sur un avant de celui-ci, le film élastique de blindage électromagnétique (350) étant adapté pour être en contact électrique élastique avec une paroi intérieure d'une partie de corps principal cylindrique (210) de la base de connexion (200).
